(19) Europäisches Patentamt
European Patent Office
Office européen des brevets

(11) **EP 4 579 436 A1**

(12) **EUROPEAN PATENT APPLICATION**

(43) Date of publication:
**02.07.2025 Bulletin 2025/27**

(21) Application number: **24215753.5**

(22) Date of filing: **27.11.2024**

(51) International Patent Classification (IPC):
**G06F 7/506** $^{(2006.01)}$     **G06F 7/533** $^{(2006.01)}$

(52) Cooperative Patent Classification (CPC):
**G06F 7/506; G06F 7/533;** G06F 2207/5063

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **28.12.2023 US 202318399595**

(71) Applicant: **Altera Corporation**
**San Jose, CA 95134 (US)**

(72) Inventors:
• **KUCHERENKO, Igor Viktorovich**
**San Jose, CA, 95134 (US)**
• **LANGHAMMER, Martin**
**Alderbury, SP5 3AB (GB)**

(74) Representative: **Samson & Partner Patentanwälte
mbB**
**Widenmayerstraße 6**
**80538 München (DE)**

(54) **MULTIPLIER WITH A NEW PARTIAL PRODUCT GENERATION METHOD**

(57)     Integrated circuit devices, methods, and circuitry for an efficient multiplier are provided. Multiplier circuitry to multiply a multiplicand value with a multiplier value may include, among other things, decoding circuitry, tripler circuitry, and partial product multiplexing circuitry. The decoding circuitry may decode bits of the multiplier value using a decoding scheme that includes at least a coding that indicates a triple, the tripler circuitry may generate a triple of the multiplicand value and may include circuitry to generate the triple of the multiplicand value that sums at least two different vectors, and the partial product multiplexing circuitry may select the triple of the multiplicand as a partial product when the coding indicates the triple.

FIG. 1

EP 4 579 436 A1

**Description**

## BACKGROUND

The present disclosure relates generally to integrated circuit (IC) devices such as processors, application specific integrated circuits (ASICs), and programmable logic devices (PLDs) that include a hardened multiplier circuit with area- and/or power-efficient partial product generation circuitry.

This section is intended to introduce the reader to various aspects of art that may be related to various aspects of the present disclosure, which are described and/or claimed below. This discussion is believed to be helpful in providing the reader with background information to facilitate a better understanding of the various aspects of the present disclosure. Accordingly, it may be understood that these statements are to be read in this light, and not as admissions of prior art.

Integrated circuits are ubiquitous in modern electronics. Many integrated circuit operations involve multiplying two values to obtain a product using a multiplier circuit. Artificial intelligence (AI) in particular involves so many multiplier instances that there may be millions of multiplier circuits or more per device. Thus, multiplier circuits may consume significant area and energy resources of an integrated circuit.

## BRIEF DESCRIPTION OF THE DRAWINGS

Various aspects of this disclosure may be better understood upon reading the following detailed description and upon reference to the drawings in which:

FIG. 1 illustrates a block diagram of a system that may implement arithmetic operations using a digital signal processing (DSP) block that includes a multiplier circuit with efficient partial product generation circuitry;

FIG. 2 illustrates an example of the integrated circuit device as a programmable logic device, such as a field-programmable gate array (FPGA);

FIG. 3 is a block diagram of an FPGA digital signal processing (DSP) block that includes a multiplier circuit with efficient partial product generation circuitry;

FIG. 4 is a block diagram of an example of the multiplier circuit;

FIG. 5 is a block diagram of an efficient tripler circuit to efficiently generate a triple of an 8-bit multiplicand to be used as a partial product;

FIG. 6 is a block diagram of components of the tripler circuit of FIG. 5;

FIG. 7 is a block diagram of an efficient tripler circuit to efficiently generate a triple of a 9-bit multiplicand to be used as a partial product;

FIG. 8 is a block diagram of components of the tripler circuit of FIG. 7;

FIG. 9 is a flowchart of a method for efficiently multiplying two values; and

FIG. 10 is a block diagram of a data processing system incorporating the efficient multiplier circuitry.

## DETAILED DESCRIPTION OF SPECIFIC EMBODIMENTS

One or more specific embodiments will be described below. In an effort to provide a concise description of these embodiments, not all features of an actual implementation are described in the specification. It should be appreciated that in the development of any such actual implementation, as in any engineering or design project, numerous implementation-specific decisions must be made to achieve the developers' specific goals, such as compliance with system-related and business-related constraints, which may vary from one implementation to another. Moreover, it should be appreciated that such a development effort might be complex and time consuming, but would nevertheless be a routine undertaking of design, fabrication, and manufacture for those of ordinary skill having the benefit of this disclosure.

When introducing elements of various embodiments of the present disclosure, the articles "a," "an," and "the" are intended to mean that there are one or more of the elements. The terms "comprising," "including," and "having" are intended to be inclusive and mean that there may be additional elements other than the listed elements. Additionally, it should be understood that references to "one embodiment" or "an embodiment" of the present disclosure are not intended to be interpreted as excluding the existence of additional embodiments that also incorporate the recited features.

This disclosure relates to efficient multiplier circuitry that may be used in any suitable integrated circuit that performs an operation that multiplies two values. By way of example, the multiplier circuit may be included in a processor (e.g., a central processing unit (CPU) or a graphics processing unit (GPU)), an application specific integrated circuit (ASIC) (e.g., a specialized artificial intelligence (AI) integrated circuit), or a programmable logic device (PLD) (e.g., in a digital signal processing (DSP) block of a field programmable gate array (FPGA) integrated circuit). The improved multiplier circuitry of this disclosure may increase performance/power/area (PPA) for digital multiplication by up to 20% over previous circuits. Indeed, the efficient multiplier circuit of this disclosure has been validated over thousands of experiments on recent process nodes. Experiments show that the results are particularly applicable to relatively lower precision (8 to 12 bit operands) multipliers used for AI and at the speed ranges (500MHz to 2GHz) at which those chips often run.

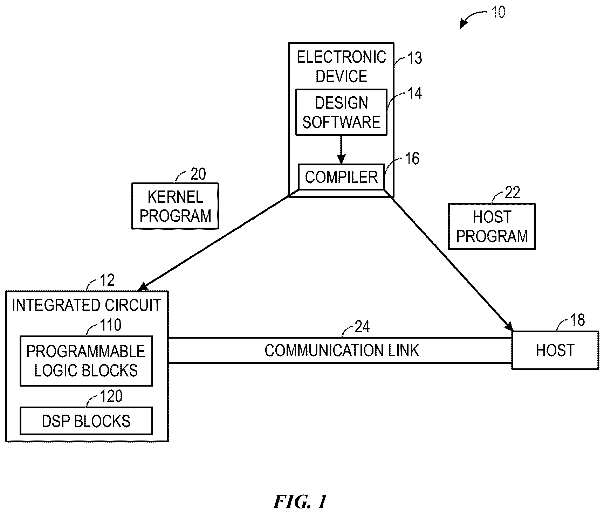

With the foregoing in mind, FIG. 1 illustrates a block diagram of one example of a system 10 that may be used to configure an integrated circuit device 12 with a DSP block that includes the efficient multiplier circuit of this disclosure. However, as mentioned above, the efficient multiplier circuit of this disclosure may be used in any suitable integrated circuit. A designer may desire to implement a system on the integrated circuit device 12 (e.g., a programmable logic device such as a field-programmable gate array (FPGA) or an application-specific integrated circuit (ASIC) that includes programmable logic circuitry). The integrated circuit device 12 may include a single integrated circuit, multiple integrated circuits in a package (e.g., a multi-chip module (MCM), a system-in-package (SiP)), or multiple integrated circuits in multiple packages communicating remotely (e.g., via wires or traces). In some cases, the designer may specify a high-level program to be implemented, such as an OPENCL® program that may enable the designer to more efficiently and easily provide programming instructions to configure a set of programmable logic cells for the integrated circuit device 12 without specific knowledge of low-level hardware description languages (e.g., Verilog, very high speed integrated circuit hardware description language (VHDL)). For example, since OPENCL® is quite similar to other high-level programming languages, such as C++, designers of programmable logic familiar with such programming languages may have a reduced learning curve than designers that are required to learn unfamiliar low-level hardware description languages to implement new functionalities in the integrated circuit device 12.

In a configuration mode of the integrated circuit device 12, a designer may use an electronic device 13 (e.g., a computer) to implement high-level designs (e.g., a system user design) using design software 14, such as a version of INTEL® QUARTUS® by INTEL CORPORATION. The electronic device 13 may use the design software 14 and a compiler 16 to convert the high-level program into a lower-level description (e.g., a configuration program, a bitstream). The compiler 16 may provide machine-readable instructions representative of the high-level program to a host 18 and the integrated circuit device 12. The host 18 may receive a host program 22 that may be implemented by the kernel programs 20. To implement the host program 22, the host 18 may communicate instructions from the host program 22 to the integrated circuit device 12 via a communications link 24 that may be, for example, direct memory access (DMA) communications or peripheral component interconnect express (PCIe) communications. In some embodiments, the kernel programs 20 and the host 18 may enable configuration of circuits including programmable logic blocks 110 and digital signal processing (DSP) blocks 120 on the integrated circuit device 12. The programmable logic blocks 110 may include circuitry and/or other logic elements and may be configurable to implement a variety of functions in combination with digital signal processing (DSP) blocks 120.

The DSP blocks 120 may include circuitry to carry out operations that involve multiplication, such as to perform multiply-accumulate operations or matrix-matrix or matrix-vector multiplication. The integrated circuit device 12 may include many (e.g., hundreds or thousands) of the DSP blocks 120. Additionally, the DSP blocks 120 may be communicatively coupled to another such that data output from one DSP block 120 may be provided to other DSP blocks 120. A DSP block 120 may include hardened arithmetic circuitry that is purpose-built for performing arithmetic operations. The hardened arithmetic circuitry of the DSP blocks 120 may be contrasted with arithmetic circuitry that may be constructed in soft logic in the programmable logic circuitry (e.g., the programmable logic blocks 110). While circuitry for performing the same arithmetic operations may be programmed into the programmable logic circuitry (e.g., the programmable logic blocks 110), doing this may take up significantly more die area, may consume more power, and/or may consume more processing time.

The designer may use the design software 14 to generate and/or to specify a low-level program, such as the low-level hardware description languages described above. Further, in some embodiments, the system 10 may be implemented without a separate host program 22. Thus, embodiments described herein are intended to be illustrative and not limiting.

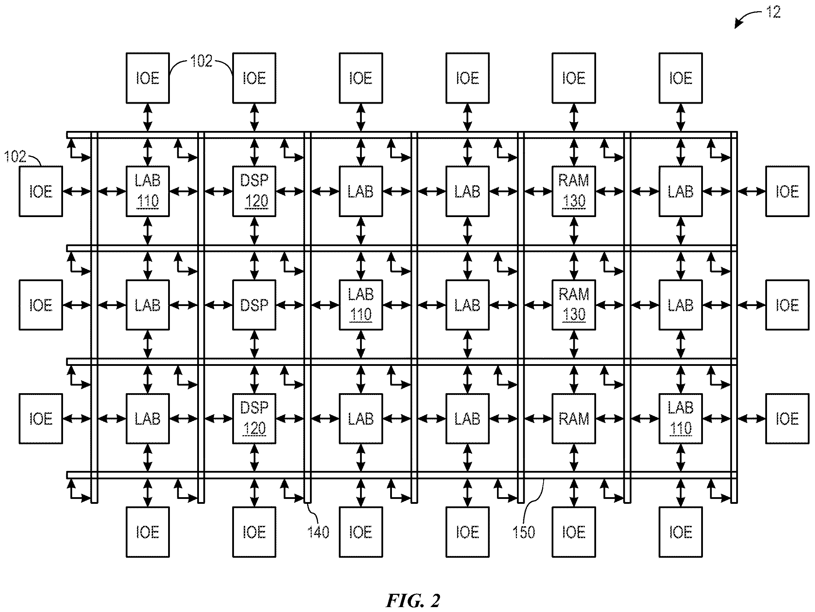

An illustrative embodiment of a programmable integrated circuit device 12 such as a programmable logic device (PLD) that may be configured to implement a circuit design is shown in FIG. 2. As shown in FIG. 2, the integrated circuit device 12 (e.g., a field-programmable gate array integrated circuit die) may include a two-dimensional array of functional blocks, including programmable logic blocks 110 (also referred to as logic array blocks (LABs) or configurable logic blocks (CLBs)) and other functional blocks, such as random-access memory (RAM) blocks 130 and digital signal processing (DSP) blocks 120, for example. Functional blocks such as LABs 110 may include smaller programmable regions (e.g., logic elements, configurable logic blocks, or adaptive logic modules) that receive input signals and perform custom functions on the input signals to produce output signals. LABs 110 may also be grouped into larger programmable regions sometimes referred to as logic sectors that are individually managed and configured by corresponding logic sector managers. The grouping of the programmable logic resources on the integrated circuit device 12 into logic sectors, logic array blocks, logic elements, or adaptive logic modules is merely illustrative. In general, the integrated circuit device 12 may include functional logic blocks of any suitable size and type, which may be organized in accordance with any suitable logic resource hierarchy.

Programmable logic circuitry of the integrated circuit device 12 may include programmable memory elements, which are sometimes referred to as configuration random access memory (CRAM). The memory elements may be loaded with configuration data (also called programming data or configuration bitstream) using input-output elements (IOEs) 102. Once loaded, the memory elements each provide a corresponding static control signal that controls the operation of an associated functional block (e.g., LABs 110, DSP 120, RAM 130, or input-output elements 102).

In one scenario, the outputs of the loaded memory elements are applied to the gates of metal-oxide-semiconductor transistors in a functional block to turn certain transistors on or off and thereby configure the logic in the functional block including the routing paths. Programmable logic circuit elements that may be controlled in this way include parts of multiplexers (e.g., multiplexers used for forming routing paths in interconnect circuits), look-up tables, logic arrays, AND, OR, NAND, and NOR logic gates, pass gates, etc.

The memory elements may use any suitable volatile and/or non-volatile memory structures such as random-access-memory (RAM) cells, fuses, antifuses, programmable read-only-memory memory cells, mask-programmed and laser-programmed structures, combinations of these structures, etc. Because the memory elements are loaded with configuration data during programming, the memory elements are sometimes referred to as configuration memory, configuration random-access memory (CRAM), or programmable memory elements. Programmable logic device (PLD) 100 may be configured to implement a custom circuit design. For example, the configuration RAM may be programmed such that LABs 110, DSP 120, and RAM 130, programmable interconnect circuitry (i.e., vertical channels 140 and horizontal channels 150), and the input-output elements 102 form the circuit design implementation.

In addition, the programmable logic device may have input-output elements (IOEs) 102 for driving signals off of the integrated circuit device 12 and for receiving signals from other devices. Input-output elements 102 may include parallel input-output circuitry, serial data transceiver circuitry, differential receiver and transmitter circuitry, or other circuitry used to connect one integrated circuit to another integrated circuit.

The integrated circuit device 12 may also include programmable interconnect circuitry in the form of vertical routing channels 140 (i.e., interconnects formed along a vertical axis of the integrated circuit 100) and horizontal routing channels 150 (i.e., interconnects formed along a horizontal axis of the integrated circuit 100), each routing channel including at least one track to route at least one wire. If desired, the interconnect circuitry may include pipeline elements, and the contents stored in these pipeline elements may be accessed during operation. For example, a programming circuit may provide read and write access to a pipeline element.

Note that routing topologies other than the topology of the interconnect circuitry depicted in FIG. 1 may be used. For example, the routing topology may include wires that travel diagonally or that travel horizontally and vertically along different parts of their extent as well as wires that are perpendicular to the device plane in the case of three-dimensional integrated circuits, and the driver of a wire may be located at a different point than one end of a wire. The routing topology may include global wires that span substantially all of the integrated circuit device 12, fractional global wires such as wires that span part of the integrated circuit device 12, staggered wires of a particular length, smaller local wires, or any other suitable interconnection resource arrangement.

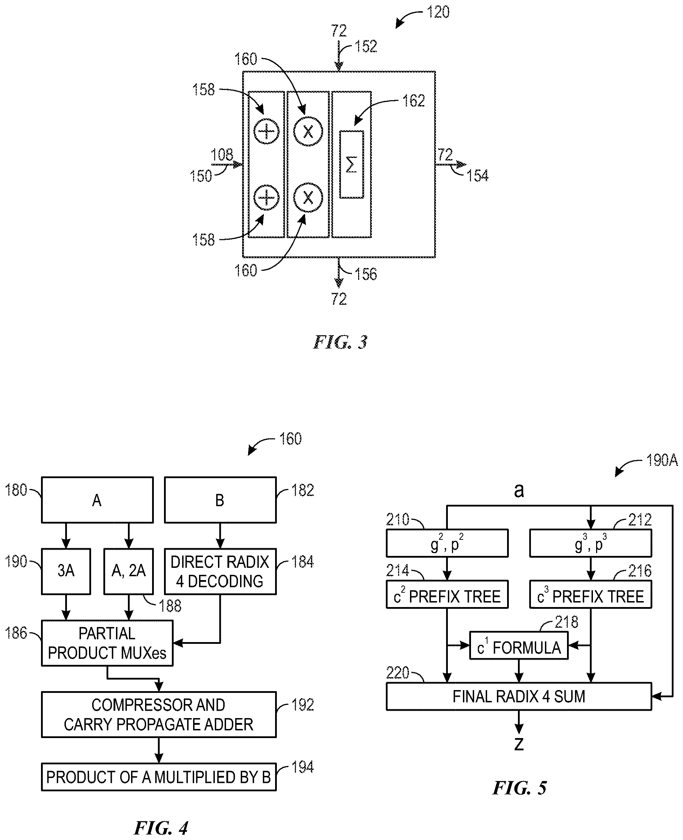

The integrated circuit device 12 may be programmed to perform a wide variety of operations. Indeed, many system designs that may be programmed into the integrated circuit device 12 may leverage the efficiency of performing arithmetic operations using the DSP blocks 120. FIG. 3 shows a block diagram of one example of a DSP Block 120 that may perform multiplication operations (e.g., as often used in digital signal processing). A number of inputs and outputs (e.g., to global FPGA routing) are provided. These signals are limited as connections to global routing are very expensive. Inputs 150 and 152 may feed data of any suitable bit width into the DSP block 120. By way of example, data of up to 108 bits may be fed into the input 150 while data of up to 72 bits may be fed into the input 152. Outputs 154 and 156 likewise may output data of any suitable width out of the DSP block 120. In the illustrated example, the outputs 154 and 156 output data with a width of 72 bits. However, it should be appreciated that any other suitable bit widths may be used (e.g., 64, 96). Pre-adders 158 may be included, as well as several multipliers 160. The multipliers 160 may be of any suitable size (e.g., INT8, INT12, INT18, INT16) and/or may be symmetric (e.g., 8x8) or asymmetric (e.g., 18x19) and summation circuitry 162 may be used to sum or accumulate the results of the pre-adders 158 and/or multipliers 160. Additional internal routing circuitry (not shown) can add the multipliers 160 together, chain the multipliers 160 together with adjacent DSP Blocks 120 or act as an accumulator via the summation circuitry 162, which may provide a summation of multiple internal results from the multipliers 160 or pre-adders 158. Additional internal routing circuitry (not shown) can combine the multipliers 160 to make larger multipliers (e.g., INT27) or even support floating point multiplication (e.g., IEEE754). The adder circuitry 158 or summation circuitry 162 can be fixed point or floating point.

FIG. 4 is a block diagram of one example of an efficient multiplier 160 to multiply a multiplicand (A) 180 with a multiplier (B) 182. The multiplier 160 may apply any suitable decoding scheme that includes a triple; here, the multiplier 160 is shown to include decoding circuitry 184 that uses direct radix 4 decoding. However, any other decoding scheme that includes a triple may be used, such as Booth's Radix 8. In essence, the multiplier 160 generates the product of the multiplicand (A) 180 and the multiplier (B) 182 by generating a series of partial products associated with different sets of bits of the multiplier (B) 182) and summing the partial products to obtain a total product.

To generate each partial product, the decoding circuitry 184 may generate a code based on the value of a set of bits of the multiplier (B) 182. Direct radix 4 decoding looks at only two bits of the multiplier (B) 182 at a time, with four possible codings: 0 (binary "00"), 1 (binary "01"), 2 (binary "10") or 3 (binary "11"), all of which may be expressed in positive terms. The decoding circuitry 184 provides the code to partial product multiplexers (MUXes) 186 that may select the partial product as 0 for code 0 (binary "00"), A (the multiplicand (A) 180) for code 1 (binary "01"), 2A (double the multiplicand (A) 180) for code 2 (binary "10"), or 3A (triple the multiplicand (A) 180) for code 3 (binary "11"). Shifter circuitry (A, 2A) 188 may provide the value A by passing the multiplicand (A) 180 or the value 2A by doubling the multiplicand (A) 180 using any suitable circuitry (e.g., by shifting and adding a 0 constant on the least significant bit). Tripler circuitry (3A) 190 may provide the value 3A by tripling the multiplicand (A) 180. The partial products may be added together using any suitable addition. Here, this is shown to be accomplished by compressor and carry propagate adder circuitry 192, the result of which is a product 194 representing the value A multiplied by the value B.

By using direct radix 4 decoding, the decoding circuitry 184 may be simplified and implemented using comparators rather than more complex logic that is often used for other decoding schemes. Indeed, consider the difference between direct radix 4 decoding and Booth's radix 4 decoding. With Booth's radix 4 decoding, two bits, and a third which is the most significant bit of the previous dibit, are used to encode the multiplicand into one of 8 cases, which are 0, 1, 2, -2, -1, 0 (or can sometimes be coded as negative 0). Two of the cases code +1, and two code -1. By comparison, direct radix 4 may avoid the use of negative coding. Indeed, one complication of the Booth's radix 4 coding method is that the generation of the negative numbers involves several potential '1' bits to be added into the result (usually in the compression tree) to create the 2's complements of the multiplicand - and this is true even for unsigned operands.

Direct radix 4 decoding is also simpler than Booth's radix 8. Booth's radix 8 takes 4 bits (3 bits plus the most significant bit of the previous 3 bits) to encode 16 combinations, which result in 9 multiplicand values (0,+1,+2,+3,+4,-4,-3,-2,-1, and 0/-0). The difficult aspect of Booth's radix 8 coding is that a +3 multiplication value may be calculated as a partial product, and the 2's complement value must be completed before compression. This is the equivalent of A+2A, which is a deep logic structure. But the advantage of Booth's radix 8 is that the number of partial products is decreased over Booth's radix 4. This may or may not result in a smaller and/or faster multiplier.

One reason that the multiplier circuit architecture of FIG. 4 has not been considered previously is that using direct radix 4 decoding produces the same number of partial products as radix 4 and the +3 coding that is also found in Booth's radix 8 involves calculating 3A, where A is the multiplicand. Indeed, previously known circuits to generate values of 3A have involved computing A+2A using multiple stages that consumed a significant circuit area, which could make the multiplier circuit architecture of FIG. 4 worse in every way. But this disclosure introduces a twist - a more efficient way of calculating A+2A to obtain 3A.

Moreover, because the multiplier circuit 160 only uses positive multiples of the multiplicand (A) 180 for partial products, there is no overhead with the adding of a vector of '1's to turn the negation of them into 2's complement values. This applies even in the case that the multiplicand (A) 180 is signed, in which case the partial product is just sign extended. There are therefore two especially notable aspects of the multiplier circuit 160 shown in FIG. 4: (1) the use of direct radix 4 approach in the decoding circuitry 184 and/or (2) the tripler circuitry (3A) 190 with an area-efficient architecture to generate A+2A.

Indeed, rather than compute a triple of the multiplicand (A) 180 as a single vector, the tripler circuitry (3A) 190 may include circuitry to generate the triple of the multiplicand value that sums at least two different vectors. For example, rather than use a single large carry prefix tree, the tripler circuitry (3A) 190 may use a carry prefix tree that is decomposed into multiple smaller carry prefix trees, as will be discussed further below. This makes the tripler circuitry (3A) 190 a much smaller, faster, energy-efficient circuit. This effect may be scaled to any suitable size input multiplicand value. What is more, the tripler circuitry (3A) 190 may operate using unsigned values, meaning that sign values may be simply passed along. Indeed, for simple (sign, value) representations of signed numbers, the tripler circuitry (3A) 190 may have exactly the same architecture, except that the sign may be passed aside. For instance, if the input is (-,5), then the output is (-,15); if the input is (+,8) then the output is (+,24). If working in 2's-complement representation, then the value into the tripler circuitry (3A) 190 may be entered "as is", with no changes into the tripler circuitry (3A) 190.

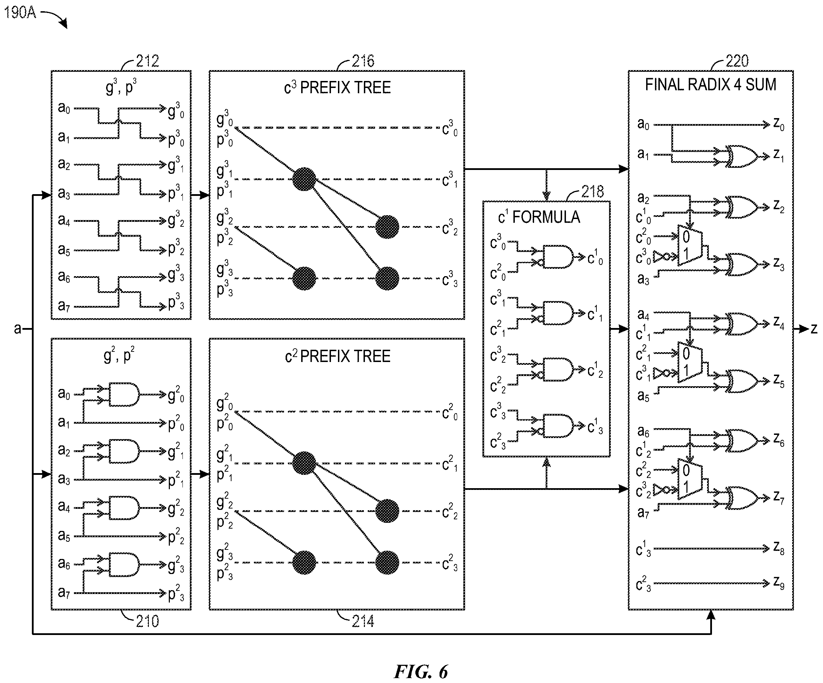

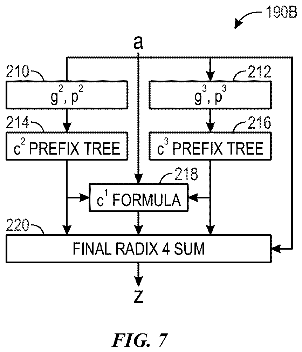

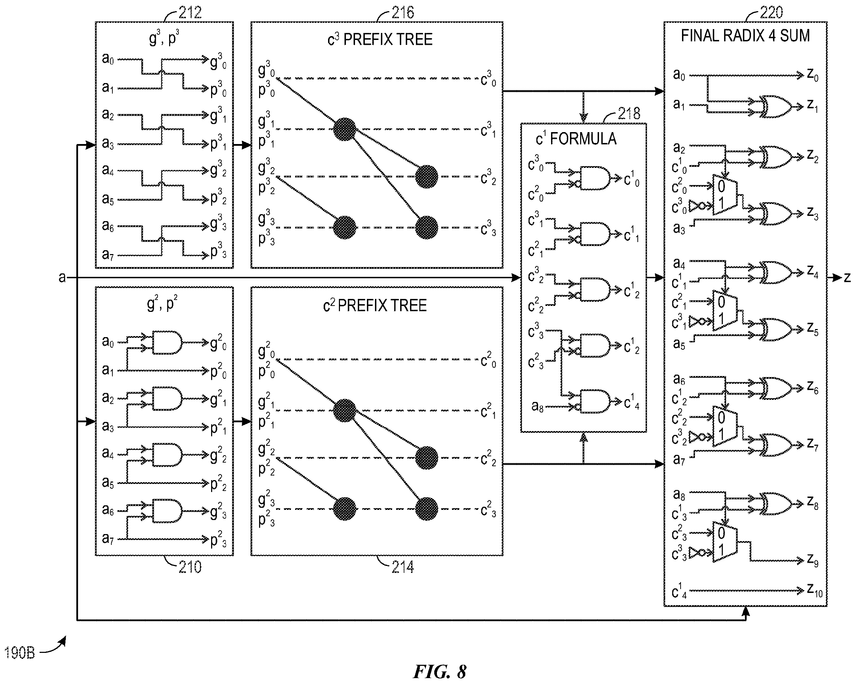

For ease of explanation, this disclosure will focus on an 8-bit example (FIGS. 5 and 6) and a 9-bit example (FIGS. 7 and 8), but it should be appreciated that these examples are not exhaustive. Indeed, the tripler circuitry (3A) 190 may be built for multiplicands of any suitable size (e.g., 10-bit, 16-bit, 18-bit, 19-bit, 32-bit) using multiple carry prefix trees in which the carry out vector remains lower than it would otherwise be for a single, larger carry prefix tree. For example, instead of having a single carry prefix tree of a larger depth (e.g., a three-stage carry prefix tree that may use a carry out vector of binary "11"), the tripler circuitry (3A) 190 may have multiple carry prefix trees of smaller depth (e.g., two two-stage carry prefix trees that may use a carry out vector of less than binary "11", meaning that the carry out vector may never be binary "11"). In another example, instead of having a single carry prefix tree of a larger depth (e.g., a four-stage carry prefix tree), the tripler circuitry (3A) 190 may have multiple carry prefix trees of smaller depth (e.g., two three-stage carry prefix trees).

FIG. 5 illustrates an 8-bit example of the tripler circuitry (3A) 190, shown here as tripler circuitry (3A) 190A. The tripler circuitry (3A) 190A receives a series of bits "a" corresponding to the multiplicand (A) 180 and may output a tripled (3A) value "z" that may be selected as a partial product in the multiplier 160. The tripler circuitry (3A) 190A includes two sets of generate and propagate circuits 210 and 212 ($g^2$, $p^2$, $g^3$, $p^3$), two carry prefix trees 214 and 216 ($c^2$; $c^3$), a combining circuit 218 ($c^1$), and summation circuitry 220 (Final radix 4 sum). By using multiple smaller carry prefix trees rather than a single larger carry prefix tree, the tripler circuitry (3A) 190A may use significantly fewer circuit gates. To reduce the total number of carry prefix tree stages, a carry truth table for the carry prefix trees 214 and 216 may be selected that avoids using at least a largest carry out vector associated with the input multiplicand. In this 8-bit example, the truth table that defines the carry prefix trees 214 and 216 never allows the carry out vector to be a binary "11," which allows an otherwise single larger carry prefix tree to be decomposed into the two smaller carry prefix trees 214 and 216, plus the combining circuit 218. An example of such a truth table is shown in Table 1 below.

Table 1. Example of Carry Truth Table for Tripler Circuitry (3A) 190A

| $c_1^3$ | $c_3\ c_2$ | $a_3\ a_2$ | $c_0^3$ | $c_1\ c_0$ | $a_1\ a_0$ |
|---|---|---|---|---|---|
| 0 | 00 | 00 | 0 | 00 | 00 |
| 0 | 00 | 01 | | | |
| 1 | 01 | 10 | | | |
| 1 | 10 | 11 | | | |
| 0 | 00 | 00 | 0 | 00 | 01 |
| 0 | 00 | 01 | | | |
| 1 | 01 | 10 | | | |
| 1 | 10 | 11 | | | |
| 0 | 00 | 00 | 1 | 01 | 10 |
| 1 | 01 | 01 | | | |
| 1 | 01 | 10 | | | |
| 1 | 10 | 11 | | | |
| 0 | 00 | 00 | 1 | 10 | 11 |
| 1 | 01 | 01 | | | |
| 1 | 10 | 10 | | | |
| 1 | 10 | 11 | | | |

This truth table may be used to build the various components of the tripler circuitry (3A) 190A. A gate-level example of the tripler circuitry (3A) 190A appears in FIG. 6. Here, the input bits ($a_0$, $a_1$, $a_2$, $a_3$, $a_4$, as, $a_6$, and $a_7$, where lower subscripts refer to less significant bits) feed into the generate and propagate circuits 210 and 212. The generate and propagate circuits 210 and 212 may use any suitable logic gates to produce generate and propagate bits ($g^2_0$, $p^2_0$, $g^2_1$, $p^2_1$, $g^2_2$, $p^2_2$, $g^2_3$, $p^2_3$, $g^3_0$, $p^3_0$, $g^3_1$, $p^3_1$, $g^3_2$, $p^3_2$, $g^3_3$, $p^3_3$) that can be used by the two carry prefix trees 214 and 216 and combining circuit 218 to generate appropriate carry bits ($c^1_0$, $c^1_1$, $c^1_2$, $c^1_3$, $c^2_0$, $c^2_1$, $c^2_2$, $c^2_3$, $c^3_0$, $c^3_1$, $c^3_2$, $c^3_3$) that, when combined in the summation circuitry 220, produce the tripled value "z" bits ($z_0$, $z_1$, $z_2$, $z_3$, $z_4$, $z_5$, $z_6$, $z_7$, $z_8$, and $z_9$). Any suitable carry prefix trees may be used. In the example of FIG. 6, the carry prefix trees 214 and 216 are Sklansky trees, where each black dot represents a generate-propagate pair. Each internal dashed line therefore represents two values. The last output (any $c_x$) drops the propagate, and the outputs of the carry prefix trees 214 and 216 are the final generate bits. Other carry prefix tree structures that may be used include Brent-Kung, Kogge-Stone, Ladner-Fisher, Han-Carson, or the like. For efficient development, the carry prefix trees 214 and 216 may be designed to have identical architectures. However, the carry prefix trees 214 and 216 may have different architectures in some embodiments. For example, one of the carry prefix trees 214 and 216 may be a Sklanksy carry prefix tree and the other of the carry prefix trees 214 and 216 may be a Brent-Kung carry prefix tree.

FIG. 7 illustrates a 9-bit example of the tripler circuitry (3A) 190, shown here as tripler circuitry (3A) 190B. The tripler circuitry (3A) 190B receives a series of bits "a" corresponding to the multiplicand (A) 180 and may output a tripled (3A) value "z" that may be selected as a partial product in the multiplier 160. The tripler circuitry (3A) 190B also includes two sets of generate and propagate circuits 210 and 212 ($g^2$, $p^2$; $g^3$, $p^3$), two carry prefix trees 214 and 216 ($c^2$; $c^3$), a combining circuit 218 ($c^1$), and summation circuitry 220 (Final radix 4 sum). By using multiple smaller carry prefix trees rather than a single larger carry prefix tree, the tripler circuitry (3A) 190B may use significantly fewer circuit gates. To accommodate the additional (ninth) input bit in comparison to the tripler circuitry (3A) 190A of FIG. 5, the tripler circuitry (3A) 190B of FIG. 7 may include the ninth bit to the combining circuitry 218.

A gate-level example of the tripler circuitry (3A) 190B appears in FIG. 8. Here, the input bits ($a_0$, $a_1$, $a_2$, $a_3$, $a_4$, $a_5$, $a_6$, and $a_7$, where lower subscripts refer to less significant bits) feed into the generate and propagate circuits 210 and 212. The generate and propagate circuits 210 and 212 may use any suitable logic gates to produce generate and propagate bits ($g^2_0$, $p^2_0$, $g^2_1$, $p^2_1$, $g^2_2$, $p^2_2$, $g^2_3$, $p^2_3$, $g^3_0$, $p^3_0$, $g^3_1$, $p^3_1$, $g^3_2$, $p^3_2$, $g^3_3$, $p^3_3$) that can be used by the two carry prefix trees 214 and 216 and combining circuit 218 to generate appropriate carry bits ($c^1_0$, $c^1_1$, $c^1_2$, $c^1_3$, $c^2_0$, $c^2_1$, $c^2_2$, $c^2_3$, $c^3_0$, $c^3_1$, $c^3_2$, $c^3_3$) that, when combined in the summation circuitry 220 with the ninth input bit ($a_8$) produce the tripled value "z" bits ($z_0$, $z_1$, $z_2$, $z_3$, $z_4$, $z_5$, $z_6$, $z_7$, $z_8$, and $z_9$). Any suitable carry prefix trees may be used. In the example of FIG. 8, the carry prefix trees 214 and 216 are Sklansky trees with the same structure as the tripler circuitry (3A) 190A shown in FIG. 6, where each black dot represents a generate-propagate pair. Each internal dashed line therefore represents two values. The last output (any $c_x$) drops the propagate, and the outputs of the carry prefix trees 214 and 216 are the final generate bits. Other carry prefix tree structures that may be used include Brent-Kung, Kogge-Stone, Ladner-Fisher, Han-Carson, or the like. For efficient development, the carry prefix trees 214 and 216 may be designed to have identical architectures. However, the carry prefix trees 214 and 216 may have different architectures in some embodiments. For example, one of the carry prefix trees 214 and 216 may be a Sklanksy carry prefix tree and the other of the carry prefix trees 214 and 216 may be a Brent-Kung carry prefix tree.

The 8-bit or 9-bit cases are among the likely use cases, as relatively smaller precisions are often used for AI applications, where it is likely that millions of multipliers may be on a single device. More generally, however, the tripler circuitry (3A) 190 may be designed to accommodate any suitable bit depth. The following explanation will provide a step-by-step description of how the tripler circuitry (3A) 190 may be designed. First, consider that one Common way to envision multiplication by 3 is 3*A = (2+1)*A = 2*A+A. This way is usually used to build 3 * A circuit: multiplication by 2 is simply shift, and adder circuitry is readily available. To construct the tripler circuitry (3A) 190, however, another way is used - it is essentially a school-book multiplication scheme for a radix 4 numeric system.

Start with representing A in the radix 4 numeric system. Without loss of generality, it may be assumed that A contains an even number of binary digits (we can add one zero upfront if the number of digits is odd), and this number is 2*N:

$$A = \sum_{i=0}^{2 \cdot N - 1} a_i \cdot 2^i.$$

In this formula, $a_i$ are individual binary digits of A (bits).

Let's group binary digits in pairs: $aa_j = a_{2j+1} * 2 + a_{2j}$. Then we can write A representation in radix 4 numeric system in the following way:

$$A = \sum_{i=0}^{2 \cdot N - 1} a_i \cdot 2^i = \sum_{j=0}^{N-1} (a_{2j+1} \cdot 2^{2j+1} + a_{2j} \cdot 2^{2j}) =$$

$$\sum_{j=0}^{N-1} (a_{2j+1} \cdot 2 + a_{2j}) \cdot 2^{2j} = \sum_{j=0}^{N-1} aa_j \cdot 4^j.$$

Let's write formula for 3 * A:

$$3 \cdot A = 3 \cdot \left( \sum_{j=0}^{N-1} aa_j \cdot 4^j \right) = \sum_{j=0}^{N-1} (3 \cdot aa_j) \cdot 4^j$$

Denote individual digit multiplication values as follows: $yy_j = (3 \cdot aa_j)/4$, $xx_j = (3 \cdot aa_j) \% 4$. In this formula (and below), a division operation is integer division and the percent operator is integer modulo reduction. The expression 3 * A may be rewritten using this notation:

$$3 \cdot A = \sum_{j=0}^{N-1} (3 \cdot aa_j) \cdot 4^j = \sum_{j=0}^{N-1} (yy_j \cdot 4 + xx_j) \cdot 4^j =$$

$$yy_{N-1} \cdot 4^N + \sum_{j=1}^{N-1} (yy_{j-1} + xx_j) \cdot 4^j + xx_0$$

Denote:

$$X = \sum_{j=0}^{N-1} xx_j \cdot 4^j \text{ and } Y = \sum_{j=0}^{N-1} yy_j \cdot 4^j$$

This produces:

$$3 \cdot A = 4 \cdot Y + X$$

Here is an example of 3 . 2926 = 8778 computation for $3 \cdot A = 4 \cdot Y + X$ formula in radix 4 numeric system (we are using binary representation for radix 4 digits: 3 is 11, 2 is 10, 1 is 01, 0 is 00):

| | | | | | | | | |
|---|---|---|---|---|---|---|---|---|
| **X** | | 10 | 11 | 01 | 10 | 11 | 10 | A |
| | | | | | | | 11 | 3 |
| | 01 | 00 | 01 | 01 | 00 | 00 | | carry |
| **+** | 01 | 10 | 00 | 01 | 10 | 01 | | 4Y |
| | | 10 | 01 | 11 | 10 | 01 | 10 | X |
| | 10 | 00 | 10 | 01 | 00 | 10 | 10 | 3A |

Table 2. Multiplication of $3 \cdot 2926 = 8778$ Computation for $3 \cdot A = 4 \cdot Y + X$ Formula

A notable observation is that X and Y are not arbitrary numbers - they have patterns of digits which "snap" together nicely. This allows construction of addition circuitry for particular numbers which is simpler than a general-purpose adder. The i-th radix 4 digit of the result may be denoted as $zz_i$, in which case:

$$\sum_{i=0}^{N} zz_i \cdot 4^i$$

Denote the sum of $4 \cdot Y$ value and radix 4 adder $4 \cdot Y + X$ carry digit string ("carry" line of Table 2) as $4 \cdot C$. Then the example can be rewritten as follows:

| | | | | | | | |
|---|---|---|---|---|---|---|---|
| X | 10 | 11 | 01 | 10 | 11 | 10 | A |
| | | | | | | 11 | 3 |
| ⊕ | 10 | 10 | 01 | 10 | 10 | 01 | 4C |
| | 10 | 01 | 11 | 10 | 01 | 10 | X |
| | 10 00 | 10 | 01 | 00 | 10 | 10 | 3A |

Table 3. Simplification of Operation shown in Table 2

Note that formula $3 \cdot A = 4 \cdot C + X$ is not correct (this is because carry would be accounted twice). But it is true that $zz_i = (xx_i + cc_{i-1}) \% 4$, where $cc_i$ are radix 4 digits of C. The resulting radix 4 digits may be calculated similar to schoolbook multiplication algorithms.

For example, a truth table may be written for $3 \cdot aa_0$:

Table 4. Truth Table for $3 \cdot aa_0$

| $aa_0$ | $yy_0$ | $xx_0$ | Comment |
|---|---|---|---|
| 00 | 00 | 00 | $0 \cdot 3 = 0$ |
| 01 | 00 | 11 | $1 \cdot 3 = 3$ |
| 10 | 01 | 10 | $2 \cdot 3 = 6$ |
| 11 | 10 | 01 | $3 \cdot 3 = 9$ |

For the first result digit, the following formula is true: $zz_0 = xx_0 = (3 \cdot aa_0) \% 4$. For the first radix 4 carry digit, the following formula is true $cc_0 = yy_0 = (3 \cdot a)/4$. Note that the value $cc_0$ cannot be binary "11" (base ten "3").

Next, compute $zz_1$. The following computations produce the second digit:

$$3 \cdot aa_1 + cc_0 = 4 \cdot yy_1 + xx_1 + cc_0 = 4 \cdot yy_1 + 4 \cdot ((xx_1 + cc_0)/4) + (xx_1 + cc_0) \% 4 = 4 \cdot (yy_1 + (xx_1 + cc_0)/4) + (xx_1 + cc_0) \% 4$$

Thus, $zz_1 = (xx_1 + cc_0) \% 4$ and $cc_1 = yy_1 + (xx_1 + cc_0)/4$. It may be proven that $cc_1$ cannot be binary "11." It is known that $cc_0 \leq 2$, and $\overline{3 \cdot aa_1} \leq 9$, so $cc_0 + 3 \cdot aa_1 \leq 11$. So $cc_1 = (cc_0 + 3 \cdot aa_1)/4 < (12/4) = 3$, or, writing shortly, $cc_1 < 3$. By induction, this means that for all $i$, $0 \leq i \leq N$, $cc_i < 3$.

The truth table for the second digit therefore may be written as follows:

Table 5. Truth Table for Second Digit

| $cc_0$ | $aa_1$ | $yy_1$ | $xx_1$ | $cc_1$ | $zz_1$ | Comment |
|---|---|---|---|---|---|---|
| 00 | 00 | 00 | 00 | 00 | 00 | $0 \cdot 3 + 0 = 0$ |
| 00 | 01 | 00 | 11 | 00 | 11 | $1 \cdot 3 + 0 = 3$ |
| 00 | 10 | 01 | 10 | 01 | 10 | $2 \cdot 3 + 0 = 6$ |
| 00 | 11 | 10 | 01 | 10 | 01 | $3 \cdot 3 + 0 = 9$ |
| 01 | 00 | 00 | 00 | 00 | 01 | $0 \cdot 3 + 1 = 1$ |
| 01 | 01 | 00 | 11 | 01 | 00 | $1 \cdot 3 + 1 = 4$ |
| 01 | 10 | 01 | 10 | 01 | 11 | $2 \cdot 3 + 1 = 7$ |
| 01 | 11 | 10 | 01 | 10 | 10 | $3 \cdot 3 + 1 = 10$ |
| 10 | 00 | 00 | 00 | 00 | 10 | $0 \cdot 3 + 2 = 2$ |
| 10 | 01 | 00 | 11 | 01 | 01 | $1 \cdot 3 + 2 = 5$ |
| 10 | 10 | 01 | 10 | 10 | 00 | $2 \cdot 3 + 2 = 8$ |

(continued)

| $cc_0$ | $aa_1$ | $yy_1$ | $xx_1$ | $cc_1$ | $zz_1$ | Comment |
|--------|--------|--------|--------|--------|--------|---------|
| 10 | 11 | 10 | 01 | 10 | 11 | $3 \cdot 3 + 2 = 11$ |

Considering that $cc_i$ value cannot be 11 binary, the truth table for all digits starting from second one would be the same.

Notably, the carry digits $cc_i$ can be directly computed without an intermediate $yy_i$ and $xx_i$ computation step. Both $xx_i$ and $yy_i$ are functions of $aa_i$, so $cc_i$ can be computed as a function of $aa_i$ and $cc_{i-1}$. Here is a truth table for $cc_i$ (it is three columns out of previous truth table put in different order):

Table 6. Truth Table for $cc_i$

| $cc_i$ | $aa_i$ | $cc_{i-1}$ |
|--------|--------|------------|
| 00 | 00 | 00 |
| 00 | 01 | 00 |
| 01 | 10 | 00 |
| 10 | 11 | 00 |
| 00 | 00 | 01 |
| 01 | 01 | 01 |
| 01 | 10 | 01 |
| 10 | 11 | 01 |
| 00 | 00 | 10 |
| 01 | 01 | 10 |
| 10 | 10 | 10 |
| 10 | 11 | 10 |

Denote the first binary digit of $cc_i$ as $c^1_i$, and second binary digit as $c^2_i$: $c^2_i = cc_i/2$, $c^1_i = cc_i \% 2$. Denote sum of $cc_i$ binary digits as $c^3_i$: $c^3_i = c^2_i + c^1_i$. If values $c^3_i$ and $c^2_i$ are available, then $c^1_i$ can be computed $c^1_i = c^3_i - c^2_i$, and $cc_i$ can be computed $cc_i = c^1_i + 2 \cdot c^2_i$. Denote $a^2_i = aa_i/2$, $a^1_i = aa_i \% 2$. A truth table for $c^3_i$ and $c^2_i$ may be expressed as follows:

Table 7. Truth Table for $c^3_i$ and $c^2_i$

| $c^3_i$ | $c^2_i$ | $cc_i$ | $aa_i$ | $cc_{i-1}$ | $c^3_{i-1}$ | $c^2_{i-1}$ |
|---------|---------|--------|--------|------------|-------------|-------------|
| 0 | 0 | 00 | 00 | 00 | 0 | 0 |
| 0 | 0 | 00 | 01 | 00 | 0 | 0 |
| 1 | 0 | 01 | 10 | 00 | 0 | 0 |
| 1 | 1 | 10 | 11 | 00 | 0 | 0 |
| 0 | 0 | 00 | 00 | 01 | 1 | 0 |
| 1 | 0 | 01 | 01 | 01 | 1 | 0 |
| 1 | 0 | 01 | 10 | 01 | 1 | 0 |
| 1 | 1 | 10 | 11 | 01 | 1 | 0 |
| 0 | 0 | 00 | 00 | 10 | 1 | 1 |
| 1 | 0 | 01 | 01 | 10 | 1 | 1 |
| 1 | 1 | 10 | 10 | 10 | 1 | 1 |
| 1 | 1 | 10 | 11 | 10 | 1 | 1 |

Boolean algebra formulas for $c^2_i$ and $c^3_i$ based on the truth table may be written:

$$c_i^2 = \left(a_i^2 \,\&\, a_i^1\right) \mid \left(c_{i-1}^2 \,\&\, a_i^2\right)$$

$$c_i^3 = a_i^2 \mid \left(c_{i-1}^3 \,\&\, a_i^1\right)$$

With these values denoted as follows:

$$g_i^2 = a_i^2 \,\&\, a_i^1, \; p_i^2 = a_i^2, \; g_i^3 = a_i^2, \; p_i^3 = a_i^1$$

Values for *c2i* and *c3i* may be rewritten:

$$c_i^2 = g_i^2 \mid \left(c_{i-1}^2 \,\&\, p_i^2\right)$$

$$c_i^3 = g_i^3 \mid \left(c_{i-1}^3 \,\&\, p_i^3\right)$$

Note that these formulas are identical to the formulas that appear in carry look ahead adder construction. This means that parallel prefix tree construction can be used for $c^2_i$ and $c^3_i$ computation (the difference is only in initial generate and propagate signal formulas). This gives $cc_i$ carry digit computations, and resulting digit computation $zz_i = (xx_i + cc_i - 1)\,\%$ 4. In this way, the tripler circuitry of this disclosure may be built for any desired bit depth.

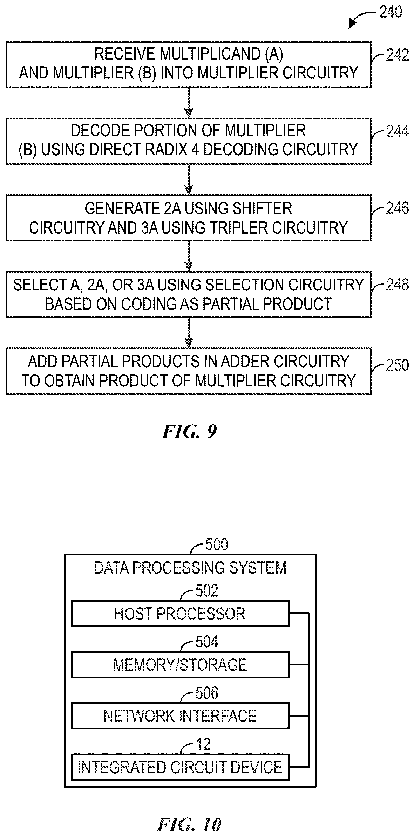

The multiplier circuit of this disclosure thus may use direct radix 4 and/or tripler circuitry to efficiently multiply two values. A flowchart 240 shown in FIG. 9 describes an example method for performing such efficient multiplication. Multiplier circuitry may receive a multiplicand (A) and a multiplier (B) to be multiplied together (block 242). Portions of the bits of the multiplier (B) may be decoded using direct radix 4 decoding (e.g., producing multiplier codings of 0, 1, 2, or 3) (block 244). Meanwhile, shifter circuitry may generate 2A values and tripler circuitry may generate 3A values (block 246) that may be selected based on the multiplier codings (block 248). For example, the selection of the partial product may be 0 for code 0 (binary "00"), A (the multiplicand (A)) for code 1 (binary "01"), 2A (double the multiplicand (A)) for code 2 (binary "10"), or 3A (triple the multiplicand (A)) for code 3 (binary "11"). The partial products that have been selected may be compressed and/or added together (block 250) to obtain the overall product of the multiplicand (A) and the multiplier (B).

An integrated circuit including the multiplier circuitry of this disclosure may be a component included in a data processing system, such as a data processing system 500, shown in FIG. 10. The data processing system 500 may include the integrated circuit system 12 (e.g., a programmable logic device), a host processor 502, memory and/or storage circuitry 504, or a network interface 506. The multiplier circuitry of this disclosure may be part of the integrated circuit system 12 (e.g., a programmable logic device), the host processor 502, the memory and/or storage circuitry 504, or the network interface 506, or another integrated circuit such as a graphics processing unit (GPU) or AI application specific integrated circuit (ASIC). The data processing system 500 may include more or fewer components (e.g., electronic display, user interface structures, application specific integrated circuits (ASICs)). The integrated circuit device 12 may be used to efficiently implement a symmetric FIR filter or perform complex multiplication. The host processor 502 may include any of the foregoing processors that may manage a data processing request for the data processing system 500 (e.g., to perform encryption, decryption, machine learning, video processing, voice recognition, image recognition, data compression, database search ranking, bioinformatics, network security pattern identification, spatial navigation, cryptocurrency operations, or the like). The memory and/or storage circuitry 504 may include random access memory (RAM), read-only memory (ROM), one or more hard drives, flash memory, or the like. The memory and/or storage circuitry 504 may hold data to be processed by the data processing system 500. In some cases, the memory and/or storage circuitry 504 may also store configuration programs (e.g., bitstreams, mapping function) for programming the integrated circuit device 12. The network interface 506 may allow the data processing system 500 to communicate with other electronic devices. The data processing system 500 may include several different packages or may be contained within a single package on a single package substrate. For example, components of the data processing system 500 may be located on several different packages at one location (e.g., a data center) or multiple locations. For instance, components of the data processing system 500 may be located in separate geographic locations or areas, such as different cities, states, or countries.

The data processing system 500 may be part of a data center that processes a variety of different requests. For instance, the data processing system 500 may receive a data processing request via the network interface 506 to perform encryption, decryption, machine learning, video processing, voice recognition, image recognition, data compression, database search ranking, bioinformatics, network security pattern identification, spatial navigation, digital signal processing, or other specialized tasks.

While the embodiments set forth in the present disclosure may be susceptible to various modifications and alternative forms, specific embodiments have been shown by way of example in the drawings and have been described in detail herein. However, it should be understood that the disclosure is not intended to be limited to the particular forms disclosed. The disclosure is to cover all modifications, equivalents, and alternatives falling within the spirit and scope of the disclosure as defined by the following appended claims.

The techniques presented and claimed herein are referenced and applied to material objects and concrete examples of a practical nature that demonstrably improve the present technical field and, as such, are not abstract, intangible or purely theoretical. Further, if any claims appended to the end of this specification contain one or more elements designated as "means for [perform]ing [a function]..." or "step for [perform]ing [a function]...", it is intended that such elements are to be interpreted under 35 U.S.C. 112(f). However, for any claims containing elements designated in any other manner, it is intended that such elements are not to be interpreted under 35 U.S.C. 112(f).

**Example Embodiments**

EXAMPLE EMBODIMENT 1. Multiplier circuitry to multiply a multiplicand value with a multiplier value, the multiplier circuitry comprising:

decoding circuitry to decode bits of the multiplier value using a decoding scheme that includes at least a coding that indicates a triple;

tripler circuitry to generate a triple of the multiplicand value, wherein the tripler circuitry comprises circuitry to generate the triple of the multiplicand value that sums at least two different vectors; and

partial product multiplexing circuitry to select the triple of the multiplicand as a partial product when the coding indicates the triple.

EXAMPLE EMBODIMENT 2. The multiplier circuitry of example embodiment 1, wherein the circuitry to generate the triple of the multiplicand value that sums the two different vectors sums the two different vectors in at least two parallel summations.

EXAMPLE EMBODIMENT 3. The multiplier circuitry of example embodiment 2, wherein the circuitry to generate the triple of the multiplicand value that sums the two different vectors comprises at least two parallel carry prefix trees.

EXAMPLE EMBODIMENT 4. The multiplier circuitry of example embodiment 1, wherein at least one of the different vectors is coded in a way that a carry value cannot propagate beyond a specified number of bits during the summation of the different vectors.

EXAMPLE EMBODIMENT 5. The multiplier circuitry of example embodiment 1, wherein the decoding scheme comprises direct radix 4 coding.

EXAMPLE EMBODIMENT 6. The multiplier circuitry of example embodiment 1, wherein the decoding scheme comprises Booth's radix 8 coding.

EXAMPLE EMBODIMENT 7. The multiplier circuitry of example embodiment 1, wherein the decoding circuitry consists essentially of comparators.

EXAMPLE EMBODIMENT 8. The multiplier circuitry of example embodiment 1, wherein the carry prefix trees have an identical architecture but receive different inputs.

EXAMPLE EMBODIMENT 9. The multiplier circuitry of example embodiment 1, wherein the carry prefix trees have a Sklansky, Brent-Kung, Kogge-Stone, Ladner-Fisher, or Han-Carson architecture.

EXAMPLE EMBODIMENT 10. One or more tangible, non-transitory, machine-readable media comprising instructions that, when executed by a data processing system, cause the data processing system to generate a circuit design comprising tripler circuitry to triple a multiplicand value, the tripler circuitry comprising:

first generate and propagate circuitry to produce a first set of generate and propagate bits based on a first set of multiplicand bits;

second generate and propagate circuitry to produce a second set of generate and propagate bits based on the first set of multiplicand bits;

a first prefix tree to produce a first set of carry bits based on the first set of generate and propagate bits;

a second prefix tree to produce a second set of carry bits based on the second set of generate and propagate bits;

combining circuitry to produce a third set of carry bits based on the first set of carry bits and the second set of carry bits; and

summation circuitry to produce a triple of the multiplicand based on the first set of carry bits, the second set of carry bits, and the third set of carry bits.

EXAMPLE EMBODIMENT 11. The one or more tangible, non-transitory, machine-readable media of example embodiment 9, wherein the first prefix tree has an identical structure to the second prefix tree.

EXAMPLE EMBODIMENT 12. The one or more tangible, non-transitory, machine-readable media of example embodiment 9, wherein the first prefix tree or the second prefix tree, or both, have a Sklansky, Brent-Kung, Kogge-Stone, Ladner-Fisher, or Han-Carson architecture.

EXAMPLE EMBODIMENT 13. The one or more tangible, non-transitory, machine-readable media of example embodiment 9, wherein the combining circuitry is to produce the third set of carry bits based on the first set of carry bits, the second set of carry bits, and a most significant bit of the multiplicand.

EXAMPLE EMBODIMENT 14. An integrated circuit device having multiplier circuitry to multiply a multiplicand value with a multiplier value, the multiplier circuitry comprising:

direct radix 4 decoding circuitry to produce one of four codes based on a portion of the multiplier value;
partial product multiplexing circuitry to:

receive a single multiplicand value, a double multiplicand value, and a triple multiplicand value;
receive the code as a selection signal; and
select as a partial product a value of 0, the single multiplicand value, the double multiplicand value, or the triple multiplicand value based on the code.

EXAMPLE EMBODIMENT 15. The integrated circuit device of example embodiment 14, wherein the direct radix 4 decoding circuitry is to produce a binary 00, 01, 10, or 11 code based on the portion of the multiplier value and the partial product multiplexing circuitry is to select as a partial product a value of 0 when the code is 00, the single multiplicand value when the value is 01, the double multiplicand value when the value is 10, and the triple multiplicand value when the value is 11.

EXAMPLE EMBODIMENT 16. The integrated circuit device of example embodiment 14, wherein the direct radix 4 decoding circuitry comprises a plurality of comparators to produce the one of the four codes based on the portion of the multiplier value.

EXAMPLE EMBODIMENT 17. The integrated circuit device of example embodiment 14, comprising tripler circuitry to generate the triple multiplicand value, wherein the tripler circuitry comprises a plurality of parallel carry prefix trees.

EXAMPLE EMBODIMENT 18. The integrated circuit device of example embodiment 17, wherein at least two of the plurality of parallel carry prefix trees are identical.

EXAMPLE EMBODIMENT 19. The integrated circuit device of example embodiment 14, wherein the integrated circuit device comprises a field programmable gate array (FPGA) having hardened digital signal processing (DSP) circuitry that comprises the multiplier circuitry.

EXAMPLE EMBODIMENT 20. The integrated circuit device of example embodiment 14, wherein the integrated circuit device comprises a central processing unit (CPU) or graphics processing unit (GPU).

## Claims

1. Multiplier circuitry to multiply a multiplicand value with a multiplier value, the multiplier circuitry comprising:

   decoding circuitry to decode bits of the multiplier value using a decoding scheme that includes at least a coding that indicates a triple;
   tripler circuitry to generate a triple of the multiplicand value, wherein the tripler circuitry comprises circuitry to generate the triple of the multiplicand value that sums at least two different vectors; and
   partial product multiplexing circuitry to select the triple of the multiplicand as a partial product when the coding indicates the triple.

2. The multiplier circuitry of claim 1, wherein the circuitry to generate the triple of the multiplicand value that sums the two different vectors sums the two different vectors in at least two parallel summations.

3. The multiplier circuitry of claim 2, wherein the circuitry to generate the triple of the multiplicand value that sums the two different vectors comprises at least two parallel carry prefix trees.

4. The multiplier circuitry of any of claims 1-3, wherein at least one of the different vectors is coded in a way that a carry value cannot propagate beyond a specified number of bits during the summation of the different vectors.

5. The multiplier circuitry of any of claims 1-4, wherein the decoding scheme comprises direct radix 4 coding.

6. The multiplier circuitry of any of claims 1-5, wherein the decoding scheme comprises Booth's radix 8 coding.

7. The multiplier circuitry of any of claims 1-6, wherein the decoding circuitry consists essentially of comparators.

8. The multiplier circuitry of any of claims 1-7, wherein the carry prefix trees have an identical architecture but receive different inputs.

9. The multiplier circuitry of any of claims 1-8, wherein the carry prefix trees have a Sklansky, Brent-Kung, Kogge-Stone, Ladner-Fisher, or Han-Carson architecture.

10. One or more tangible, non-transitory, machine-readable media comprising instructions that, when executed by a data processing system, cause the data processing system to generate a circuit design comprising tripler circuitry to triple a multiplicand value, the tripler circuitry comprising:

first generate and propagate circuitry to produce a first set of generate and propagate bits based on a first set of multiplicand bits;
second generate and propagate circuitry to produce a second set of generate and propagate bits based on the first set of multiplicand bits;
a first prefix tree to produce a first set of carry bits based on the first set of generate and propagate bits;
a second prefix tree to produce a second set of carry bits based on the second set of generate and propagate bits;
combining circuitry to produce a third set of carry bits based on the first set of carry bits and the second set of carry bits; and
summation circuitry to produce a triple of the multiplicand based on the first set of carry bits, the second set of carry bits, and the third set of carry bits.

11. The one or more tangible, non-transitory, machine-readable media of claim 10, wherein the first prefix tree has an identical structure to the second prefix tree.

12. The one or more tangible, non-transitory, machine-readable media of claim 10 or 11, wherein the first prefix tree or the second prefix tree, or both, have a Sklansky, Brent-Kung, Kogge-Stone, Ladner-Fisher, or Han-Carson architecture.

13. The one or more tangible, non-transitory, machine-readable media of any of claims 10-12, wherein the combining circuitry is to produce the third set of carry bits based on the first set of carry bits, the second set of carry bits, and a most significant bit of the multiplicand.

14. The one or more tangible, non-transitory, machine-readable media of any of claims 10-13, wherein the instructions, when executed by the data processing system, cause the data processing system to generate the circuit design, wherein the circuit design comprises multiplier circuitry to multiply a multiplicand value with a multiplier value, the multiplier circuitry comprising:

direct radix 4 decoding circuitry to produce one of four codes based on a portion of the multiplier value;
partial product multiplexing circuitry to:

receive a single multiplicand value, a double multiplicand value, and a triple multiplicand value;
receive the code as a selection signal; and
select as a partial product a value of 0, the single multiplicand value, the double multiplicand value, or the triple multiplicand value based on the code.

15. The one or more tangible, non-transitory, machine-readable media of any of claims 10-14, wherein the triple multiplicand value is provided by the tripler circuitry.

**FIG. 1**

**FIG. 2**

*FIG. 3*

*FIG. 4*

*FIG. 5*

FIG. 6

*FIG. 7*

*FIG. 8*

*FIG. 9*

*FIG. 10*

Europäisches
Patentamt

European
Patent Office

Office européen
des brevets

**EUROPEAN SEARCH REPORT**

**Application Number**

EP 24 21 5753

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | RUIZ ET AL: "Efficient implementation of 3X for radix-8 encoding", MICROELECTRONICS JOURNAL, MACKINTOSH PUBLICATIONS LTD. LUTON, GB, vol. 39, no. 1, 11 January 2008 (2008-01-11), pages 152-159, XP022414912, ISSN: 0026-2692, DOI: 10.1016/J.MEJO.2007.10.006 * Section 2, 3; figures 2, 3 * | 1-15 | INV. G06F7/506 G06F7/533 |
| X | US 4 864 529 A (SHAH IMRAN A [US] ET AL) 5 September 1989 (1989-09-05) * column 4, line 37 - line 68 * | 1,2,4-7, 13-15 | |
| X | US 5 875 125 A (HWANG WEI [US] ET AL) 23 February 1999 (1999-02-23) * column 2, line 65 - column 3, line 39; figures 4,5 * * column 4, line 1 - line 24; figure 8 * * column 1, line 5 - line 57 * | 1,2,4-7, 13-15 | |

TECHNICAL FIELDS
SEARCHED      (IPC)

G06F

The present search report has been drawn up for all claims

| Place of search | Date of completion of the search | Examiner |
|---|---|---|
| Munich | 25 April 2025 | Prins, Leendert |

EPO FORM 1503 03.82 (P04C01)

## ANNEX TO THE EUROPEAN SEARCH REPORT
## ON EUROPEAN PATENT APPLICATION NO.

EP 24 21 5753

This annex lists the patent family members relating to the patent documents cited in the above-mentioned European search report.
The members are as contained in the European Patent Office EDP file on
The European Patent Office is in no way liable for these particulars which are merely given for the purpose of information.

25-04-2025

| Patent document cited in search report | Publication date | Patent family member(s) | Publication date |
|---|---|---|---|
| US 4864529 A | 05-09-1989 | NONE | |
| US 5875125 A | 23-02-1999 | NONE | |

EPO FORM P0459

For more details about this annex : see Official Journal of the European Patent Office, No. 12/82